# EUROPEAN PATENT SPECIFICATION

(11) **EP 1 562 235 B1**
(45) Date of publication and mention of the grant of the patent: **30.12.2009**
(21) Application number: 05250389.3
(22) Date of filing: 26.01.2005
(51) Int. Cl.: H01L 27/24, H01L 45/00

(54) **Semiconductor memory device and its manufacturing method**
Halbleiterspeicherbauelement und dessen Herstellungsverfahren
Dispositif à mémoire semiconducteur et procédé de fabrication

(30) Priority: 28.01.2004 JP 2004019261; 18.03.2004 JP 2004077797
(43) Date of publication of application: 10.08.2005
(73) Proprietor: Sharp Kabushiki Kaisha, Osaka 545-8522 (JP)
(72) Inventor: Yokoyama, Takashi, Fukuyama-shi, Hiroshima 721-0902 (JP); Tanigami, Takuji, Kashihara-shi, Nara 630-0045 (JP)
(74) Representative: Brown, Kenneth Richard

(56) References cited:
- EP-A- 1 376 598
- EP-A- 1 403 920
- US-A1- 2003 132 501
- US-B1- 6 204 139

## Description

### BACKGROUND OF THE INVENTION

### 1. Field of the Invention

The present invention relates to a semiconductor memory device comprising a variable resistive element in a memory cell and its manufacturing method.

### 2. Description of the Related Art

There has been proposed a method of changing electric characteristic of a thin film or a bulk formed of a thin film material having a perovskite structure, especially a CMR (Colossal Magnetoresistance) material or a HTSC (High Temperature Superconductivity) material, by applying one or more short electric pulses. An electric field strength and a current density of this electric pulse is enough to change a physical state of the material and its energy is low enough so as not to destroy the material and the electric pulse may be a positive polarity or a negative polarity. In addition, when the plurality of electric pulses is repeatedly applied, the material characteristics can be further changed.

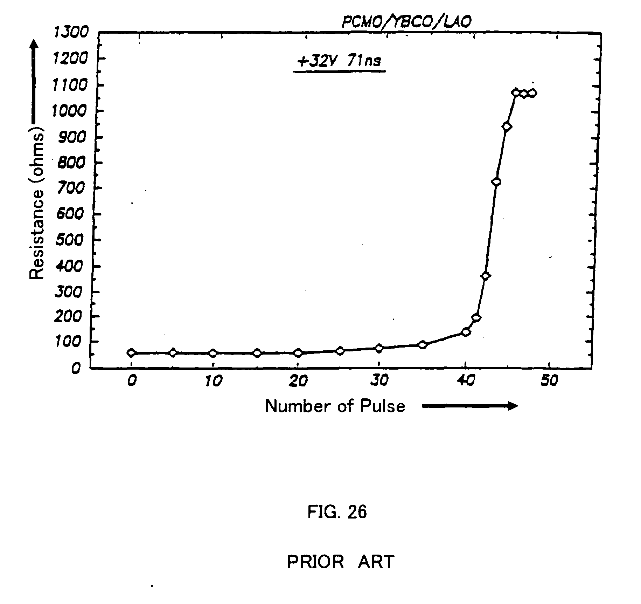

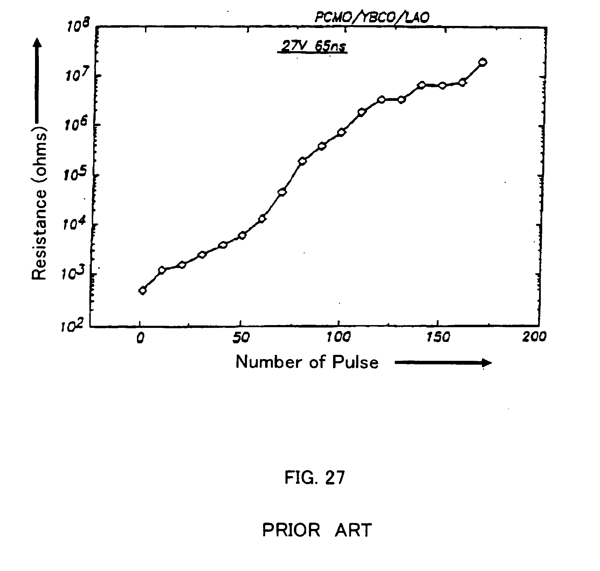

Such conventional technique is disclosed in a specification in US Patent No. 6,204,139, for example. Figs. 26 and 27 are graphs each showing relations between the number of pulses and a resistance value in the conventional technique. Fig. 26 shows the number of pulses applied to a CMR film grown on a metal substrate and its resistance. Here, a pulse having amplitude of 32 V and a pulse width of 71 ns is applied 47 times. Under such condition, the resistance value can be changed about one digit as can be seen from Fig. 26.

Meanwhile, in Fig. 27 the pulse applying condition is changed and a pulse having amplitude of 27 V and a pulse width of 65 ns is applied 168 times. Under such conditions, the resistance value is changed as much as about five digits as can be seen from Fig. 27.

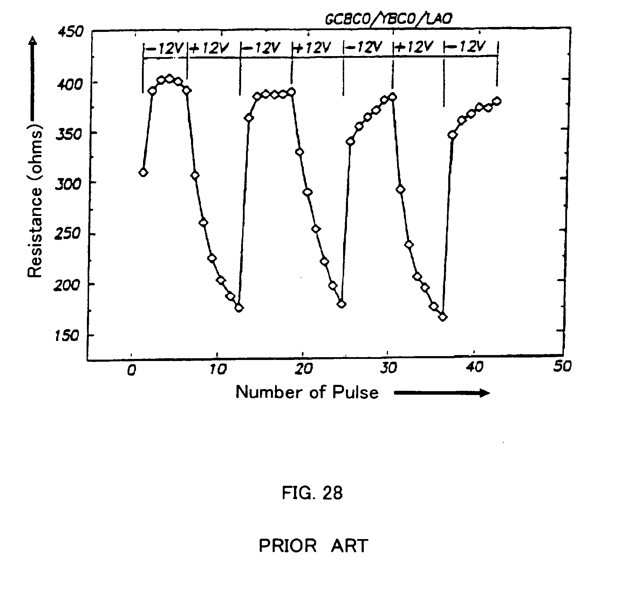

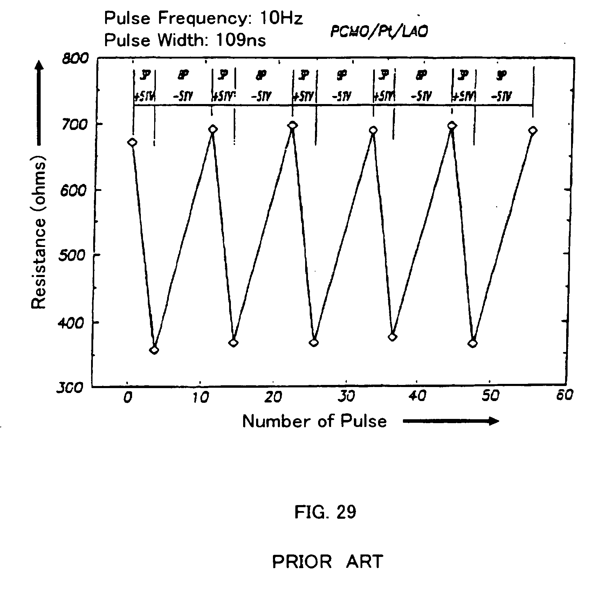

Figs. 28 and 29 are graphs showing dependency on a polarity of the pulse in the conventional technique.

Fig. 28 shows a relation between the number of pulses and resistance when the pulse of positive polarity of +12 V and negative polarity -12 V is applied.

In addition, Fig. 29 shows a relation between the number of pulses and resistance when a resistance value is measured after the pulses of positive polarity of +51 V and negative polarity of -51 V are continuously applied. As shown in Figs. 28 and 29, the resistance value can be increased (to a saturated state finally) by continuously applying the pulses of the negative polarity after the resistance value is reduced by applying the pulse of the positive polarity several times. This fact can be applied to a memory device when it is assumed that a reset state is the case when the positive polarity pulse is applied and a programming state is the case when the negative polarity pulse is applied.

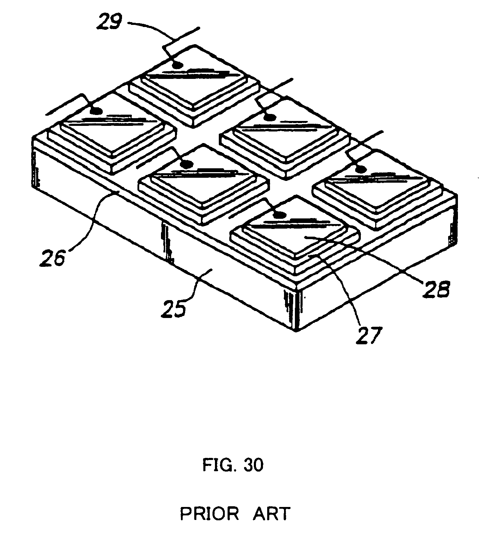

According to the conventional example, the CMR thin films having the above characteristics are arranged in the form of an array to constitute a memory. Fig. 30 is a perspective view showing a memory array constitution in the conventional technique.

According to the memory array shown in Fig 30, a bottom electrode 26 is formed on a substrate 25, and a variable resistive element 27 and an upper electrode 28 which constitute one bit are formed thereon. A wire 29 is connected to each variable resistive element 27, that is, to the upper electrode 28 in each bit and pulses for programming are applied through it. In addition, at the time of reading, a current is read from the wire 29 connected to the upper electrode 28 of each bit.

However, the change in resistance value of the CMR thin film shown in Figs. 28 and 29 is about two times, and the variation in the resistance value seems to be small to distinguish the resetting state from the programming state. In addition, since the voltage applied to the CMR thin film is high, it is not suitable for the memory device in which a low voltage operation is required.

Based on the above result, the applicant of this specification and the like found new characteristics by applying one or more short electric pulses using a CMR material of PCMO (Pr_{0.7}Ca_{0.3}MnO₃) having the same perovskite structure as the specification in US Patent No. 6,204,139 and the like. That is, it is found that there is provided the characteristics in which the resistance value of the thin film material changes from several hundred of Ω to about 1 MΩ by applying low voltage pulses of about ±5 V

Thus, patent application for the present invention is filed, which conceptually shows a circuit system in which the memory array is formed of the above material so as to perform the reading and programming operation.

However, according to the memory array shown in Fig. 30, since the wire is connected to the electrode bit by bit and programming pulses are applied through the wire at the time of programming operation and a current is read through the wire connected to the electrode bit by bit is read at the time of the reading operation, the characteristics of the thin film material can be evaluated, but a degree of integration cannot be increased.

In addition, the programming operation, the reading operation and the resetting operation are entirely controlled by an input signal from the outside of the memory, which is different from the conventional memory in which the programming operation, the reading operation and the resetting operation are controlled inside the memory device.

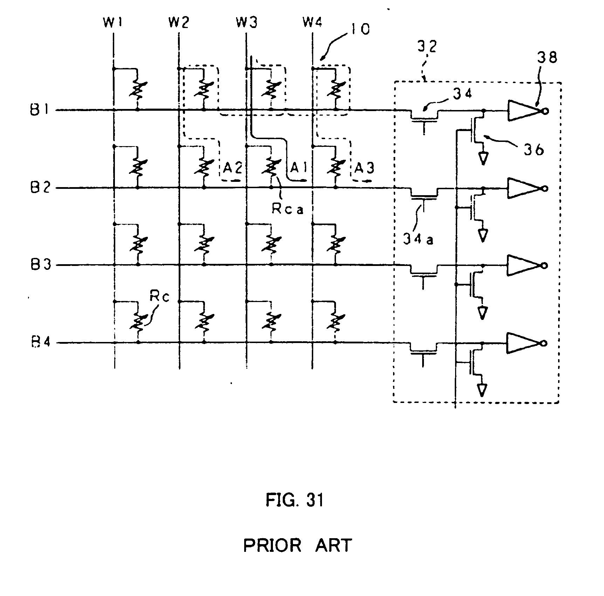

Fig. 31 is a circuit diagram showing a constitution of a conventional memory array. Variable resistive elements Rc formed of the PCMO material are arranged in the form of a matrix of 4 x 4 to constitute a memory array 10. One ends of the variable resistive elements Rc are connected to word lines W1 to W4 and the other ends thereof are connected to bit line B 1 to B4. Peripheral circuits 32 are formed adjacent to the memory array 10. A bit-pass transistor 34 is connected to each of the bit lines B1 to B4 to form a path to an inverter 38. A load transistor 36 is connected between the bit-pass transistor 34 and the inverter 38. According to this constitution, the reading and programming operations can be performed in each variable resistive element Rc of the memory array 10.

According to the conventional memory array, the memory can be operated at a low voltage. However, in this programming and reading operations, since a leak current path to a memory cell adjacent to the memory cell to be accessed is generated, a correct current value cannot be evaluated at the time of reading (reading disturbance) and a correct programming could not be performed at the time of programming (programming disturbance).

For example, the resistance value of the variable resistive element Rca in the selected memory cell can be read and a current path shown by an arrow A1 is formed by applying a power supply voltage Vcc to the word line W3 and the GND to the bit line B2, and opening the other bit lines B1, B3 and B4 and the word lines W1, W2 and W4, and turning on the bit-pass transistor 34a. However, since current paths shown by arrows A2, A3 and the like are generated in the variable resistive elements Rc adjacent to the variable resistive element Rca, only the resistance value in the variable resistive element Rca in the selected memory cell cannot be read (reading disturbance).

In addition, when there is fluctuation in external resistance of the current path connected to the variable resistive element, an enough voltage for the programming operation cannot be applied to the variable resistive element, so that a programming defect could be generated, or a reading defect could be generated because of current deficiency caused by the fluctuation in the external resistance.

EP 1 376 598A discloses a memory cell having a variable resistor as a memory element, and also provides a memory device comprising the memory cells. The variable resistor is made of a thin-film material (for example, PCMO) or the like having a perovskite structure. So the memory cell can operate at a low voltage and can be highly integrated. The memory cell is formed of a combination of a current controlling device and a variable resistor. A field-effect transistor, diode or bipolar transistor is used as the current controlling device. The current controlling device is connected in series with the current path of the variable resistor so as to control a current flowing through the variable resistor.

### SUMMARY OF THE INVENTION

The present invention has been made in view of the above problems and it is an object of the present invention to provide a memory cell which can operate a variable resistive element formed of a thin film material (PCMO, for example) having a perovskite structure and the like at a low voltage as a memory element and can be highly integrated, and a semiconductor memory device using this memory cell. In addition, it is another object of the present invention to provide a semiconductor memory device in which a leak current to an adjacent memory cell when the memory cell is accessed is not generated and furthermore, to provide a high-performance semiconductor memory device in which variation in characteristics of the memory cell is prevented.

A memory cell of a semiconductor memory device according to the present invention in order to attain the above objects comprises a variable resistive element; and a selection transistor comprising a bipolar transistor which can control a current flowing in the variable resistive element bi-directionally, **characterised in that** an upper electrode of either a collector or an emitter of the bipolar transistor is stacked on a base of the bipolar transistor and the variable resistive element is stacked on the upper electrode of the bipolar transistor to be connected to the upper electrode of the bipolar transistor, one of two parallel sidewall surfaces of the base of the bipolar transistor, one of two parallel sidewall surfaces of the upper electrode of the bipolar transistor and one of two parallel sidewall surfaces of the variable resistive element are aligned with each other to form a vertical surface, and the other of the two parallel sidewall surfaces of the base of the bipolar transistor, the other of the two parallel sidewall surfaces of the upper electrode of the bipolar transistor and the other of the two parallel sidewall surfaces of the variable resistive element are aligned with each other to form another vertical surface.

According to the memory cell of the present invention, since the constitution comprising the variable resistive element and the selection transistor is simple, there can be provided a memory cell suitable for a high-capacity memory device. Especially, since the bipolar transistor employed as the selection transistor can be formed perpendicularly to the semiconductor substrate, a memory size can be as small as a memory cell comprising only a variable resistive element without the selection transistor, so that a memory cell constitution suitable for high capacity can be implemented. Furthermore, since the current flowing in the variable resistive element can be controlled bi-directionally by the selection transistor, a leak current to an adjacent memory cell can be prevented regardless of the current direction flowing in the variable resistive element. In addition, when the variable resistive element is positioned by self-aligning and it is connected to one electrode of the selection transistor, the characteristics of the memory cell can be prevented from being varied, which contributes to high performance.

A semiconductor memory device according to the present invention in order to attain the above objects comprises a memory array on a semiconductor substrate, which memory array is constituted such that a plurality of the above memory cells in which one end of the variable resistive element is connected to either one of an emitter or a collector of the bipolar transistor are arranged in the row direction and the column direction in the form of a matrix, a base of the bipolar transistor in each memory cell in the same row is connected to a common word line extending in the row direction, the other end of the variable resistive element in each memory cell in the same column is connected to a common bit line extending in the column direction, wherein the other of the emitter or the collector of the bipolar transistor in each memory cell in the same column is connected to a common source line extending in the column direction.
In addition to the above characteristics, the semiconductor memory device according to the present invention is characterized in that the source line is formed on the semiconductor substrate as a striped p-type or n-type semiconductor layer, the word line is formed on the source line as a striped semiconductor layer whose conductive type is different from that of the source line, a junction between the base and the emitter or a junction between the base and the collector of the bipolar transistor in each memory cell is formed on a contact face between the source line and the word line on which the source line intersects with the word line. Furthermore, it is characterized in that either one of the emitter or the collector of the bipolar transistor connected to one end of the variable resistive element in each memory cell is formed of a semiconductor layer having the same conductivity type as the source line on the word line where the source line intersects with the word line, and the variable resistive element in each memory cell is formed on either one of the emitter or the collector of the bipolar transistor connected to the one end of the variable resistive element at each intersection of the source line with the word line, and the bit line is formed on the variable resistive element. Still further, it is characterized in that the bit line comprising a contact which electrically comes in contact with the variable resistive element is connected to the variable resistive element, one of two parallel sidewall surfaces of the contact and one of two parallel sidewall surfaces of the variable resistive element are aligned with each other to form a vertical surface, and the other of the two parallel sidewall surfaces of the contact and the other of the two parallel sidewall surfaces of the variable resistive element are aligned with each other to form another vertical surface.

According to the above characteristics of the semiconductor memory device of the present invention, there can be provided a semiconductor memory device which can produce an operation effect by the above characteristics of the memory cell of the present invention, implement high-capacity semiconductor memory device, prevent generation of the leak current between memory cells, and operate at a low voltage. Especially, since the variable resistive element and the bipolar transistor, or the variable resistive element and the bit line are connected by self-aligning, characteristics fluctuation can be prevented, which contributes to high performance.

In addition to the above characteristics, the semiconductor memory device according to the present invention has one of two parallel sidewall surfaces of the bit line and one of two parallel sidewall surfaces of the variable resistive element are aligned with each other to form a vertical surface, and the other of the two parallel sidewall surfaces of the bit line and the other of the two parallel sidewall surfaces of the variable resistive element are aligned with each other to form another vertical surface. In addition, it is characterized in that each electrode of the selection transistor and the variable resistive element are laminated perpendicularly to a semiconductor substrate.

According to the above characteristics of the semiconductor memory device of the present invention, there can be provided a semiconductor memory device which produces an operation effect of the memory cell while preventing the characteristics fluctuation, implements high-capacity semiconductor memory device, prevents a leak current from being generated between the memory cells and operates at a low voltage.

A method of manufacturing the semiconductor memory device according to the present invention in order to attain the above objects is characterized by comprising a step of forming an element isolation region on the semiconductor substrate, a step of forming a first semiconductor layer serving as the source line between the element isolation regions, a step of depositing a second semiconductor layer a part of which becomes the word line and a third semiconductor layer a part of which becomes either one of an emitter or a collector of the bipolar transistor connected to one end of the variable resistive element, on the first semiconductor layer and the element isolation region, a step of patterning a part of the third semiconductor layer, a step of patterning another part of the third semiconductor layer and the second semiconductor layer, and a step of forming the variable resistive element on the third semiconductor layer after having bun patterned two times.

According to the method of manufacturing the semiconductor memory device having the above characteristics of the present invention, since the variable resistive element and the selection transistor can be formed at the intersection of the word line with the bit line perpendicularly to the semiconductor substrate in each memory cell, there can be provided a memory array which can be provided at high density. As a result, a high-capacity semiconductor memory device can be provided at low cost. Especially, the variable resistive element can be formed on the patterned third semiconductor layer by self-aligning, and the characteristics of the memory cell can be prevented from fluctuating.

### BRIEF DESCRIPTION OF THE DRAWINGS

Fig. 1 is an equivalent circuit showing a constitution example of memory cells and a memory array according to the present invention;
Fig. 2 is a layout showing a constitution example of memory cells and a memory array according to the present invention;
Fig. 3 is a sectional view showing manufacturing steps of memory cells and a memory array in one embodiment of a manufacturing method of a semiconductor memory device according to the present invention;
Fig. 4 is a sectional view showing manufacturing steps of the memory cells and the memory array in one embodiment of the manufacturing method of the semiconductor memory device according to the present invention;
Fig. 5 is a sectional view showing manufacturing steps of the memory cells and the memory array in one embodiment of the manufacturing method of the semiconductor memory device according to the present invention;
Fig. 6 is a sectional view showing manufacturing steps of the memory cells and the memory array in one embodiment of the manufacturing method of the semiconductor memory device according to the present invention;
Fig. 7 is a sectional view showing manufacturing steps of the memory cells and the memory array in one embodiment of the manufacturing method of the semiconductor memory device according to the present invention;
Fig. 8 is a sectional view showing manufacturing steps of the memory cells and the memory array in one embodiment of the manufacturing method of the semiconductor memory device according to the present invention;
Fig. 9 is a sectional view showing manufacturing steps of the memory cells and the memory array in one embodiment of the manufacturing method of the semiconductor memory device according to the present invention;
Fig. 10 is a sectional view showing manufacturing steps of the memory cells and the memory array in one embodiment of the manufacturing method of the semiconductor memory device according to the present invention;
Fig. 11 is a sectional view showing manufacturing steps of the memory cells and the memory array in one embodiment of the manufacturing method of the semiconductor memory device according to the present invention;
Fig. 12 is a sectional view showing manufacturing steps of the memory cells and the memory array in one embodiment of the manufacturing method of the semiconductor memory device according to the present invention;
Fig. 13 is a sectional view showing manufacturing steps of the memory cells and the memory array in one embodiment of the manufacturing method of the semiconductor memory device according to the present invention;
Fig. 14 is a sectional view showing manufacturing steps of the memory cells and the memory array in one embodiment of the manufacturing method of the semiconductor memory device according to the present invention;
Fig. 15 is a sectional view showing manufacturing steps of the memory cells and the memory array in one embodiment of the manufacturing method of the semiconductor memory device according to the present invention;
Fig. 16 is a sectional view showing manufacturing steps of the memory cells and the memory array in one embodiment of the manufacturing method of the semiconductor memory device according to the present invention;
Fig. 17 is a sectional view showing manufacturing steps of the memory cells and the memory array in one embodiment of the manufacturing method of the semiconductor memory device according to the present invention;
Fig. 18 is a sectional view showing manufacturing steps of memory cells and a memory array in another embodiment of the manufacturing method of the semiconductor memory device according to the present invention;
Fig. 19 is a sectional view showing manufacturing steps of the memory cells and the memory array in another embodiment of the manufacturing method of the semiconductor memory device according to the present invention;
Fig. 20 is a sectional view showing manufacturing steps of the memory cells and the memory array in another embodiment of the manufacturing method of the semiconductor memory device according to the present invention;
Fig. 21 is a sectional view showing manufacturing steps of the memory cells and the memory array in another embodiment of the manufacturing method of the semiconductor memory device according to the present invention;
Fig. 22 is a perspective view showing a constitution example of the memory array in the semiconductor memory device according to the present invention;
Fig. 23 is a sectional view showing manufacturing steps of memory cells and a memory array in a third embodiment of the manufacturing method of the semiconductor memory device according to the present invention;
Fig. 24 is a sectional view showing manufacturing steps of the memory cells and a memory array in the third embodiment of the manufacturing method of the semiconductor memory device according to the present invention;
Fig. 25 is a sectional view showing manufacturing steps of the memory cells and the memory array in the third embodiment of the manufacturing method of the semiconductor memory device according to the present invention;
Fig. 26 is a graph showing a relation between the number of pulses and a resistance value in a variable resistive element in conventional technique;
Fig. 27 is a graph showing a relation between the number of pulses and a resistance value in a variable resistive element in the conventional technique;
Fig. 28 is a graph showing dependency of the variable resistive element on a polarity of applied pulses in the conventional technique;
Fig. 29 is a graph showing dependency of the variable resistive element on a polarity of applied pulses in the conventional technique;
Fig. 30 is a perspective view showing a conventional memory array constitution of memory cells comprising variable resistive elements; and
Fig. 31 is a circuit diagram showing an example of the conventional memory array constitution of the memory cells comprising variable resistive elements.

### DESCRIPTION OF PREFERRED EMBODIMENTS

A semiconductor memory device and its manufacturing method according to embodiments of the present invention will be described in detail with reference to the accompanying drawings hereinafter. According to the present invention, a CMR material (PCMO: Pr_{0.7}Ca_{0.3}MnO₃, for example) thin film is used as a variable resistive element in which a resistance value is changed about two digits by low-voltage pulses as described above, and memory cells and a memory array comprises a current control element which controls a current flowing in the variable resistive element. There will be shown a concrete manufacturing method which implements a programming operation, a reading operation and a resetting operation for the memory cell and the memory array.

The memory cell according to the present invention uses a thin film material of PCMO and the like as the variable resistive element, and uses an NPN-junction bipolar transistor (referred to as the bipolar transistor hereinafter) as a selection transistor for the current control element, for example.

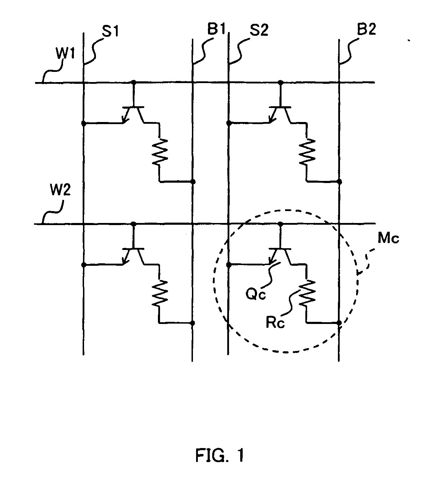

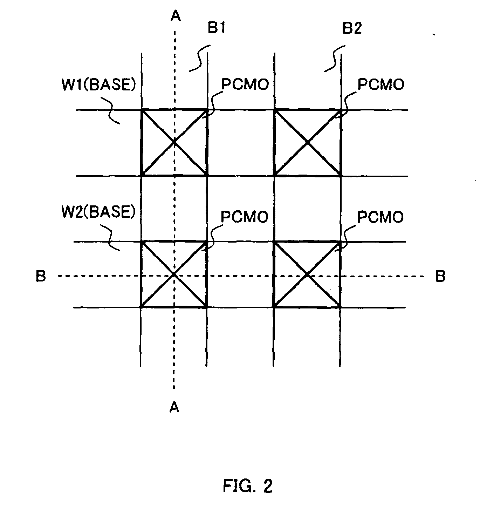

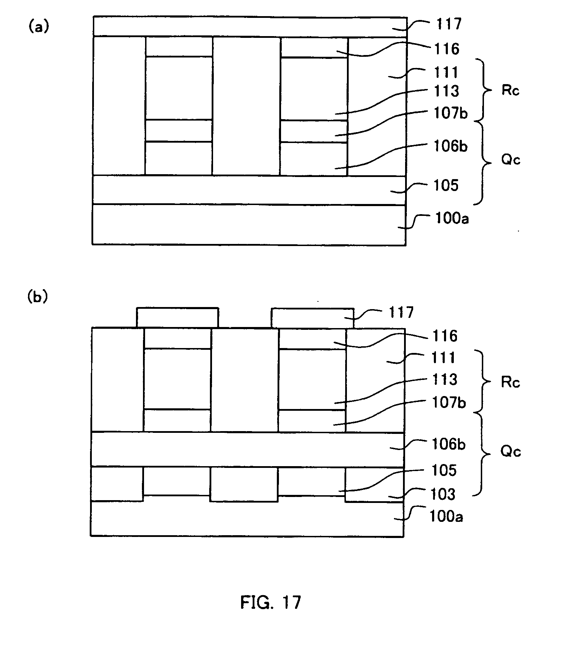

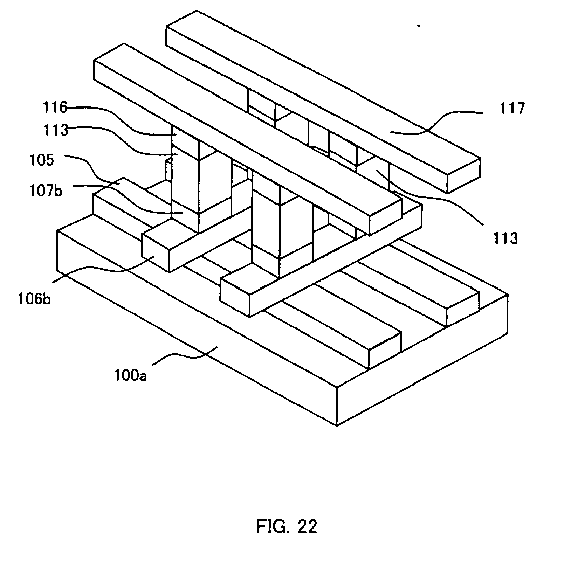

Fig. 1 shows an equivalent circuit of an array constitution in which memory cells Mc according to the present invention are arranged by 2 x 2 in the form of a matrix to be a memory array. Fig. 2 is a schematic plan view showing the memory array shown in Fig. 1. Fig. 17(a) is a schematic sectional view taken along A-A line of Fig. 2, and Fig. 17(b) is a schematic sectional view taken along B-B line of Fig. 2. Fig. 22 is a perspective view showing a memory array constitution in Figs. 1 and 2.

As shown in Fig. 1, the memory cell Mc is constituted such that one end of a variable resistive element Rc is connected to either an emitter or a collector (collector in Fig. 1) of a bipolar transistor Qc. A memory array is constituted such that the other of the emitter or the collector (emitter in Fig. 1) of the bipolar transistor Qc of each memory cell Mc in the same column is connected to a common source line S1 or S2 which extends in the column direction, a base of the bipolar transistor Qc in each memory cell Mc in the same row is connected to a common word line W1 or W2 which extends in the row direction, and the other end of the variable resistive element Rc in each memory cell Mc in the same column is connected to a common bit line B1 or B2 which extends in the column direction.

According to the schematic plan view in Fig. 2, source lines S1 and S2 (not shown) are formed below the bit lines B1 and B2, respectively. In addition, the bipolar transistor (not shown) is formed below the variable resistive element PCMO.

More specifically, as shown in Fig. 22, n-type silicon source lines 105 are arranged on a p-type silicon substrate 100a, for example serving as a semiconductor substrate, p-type silicon word lines 106b are arranged so as to cross the source lines 105 at right angles, and n-type silicon electrode (collectors) 107b are arranged on intersections of the source lines 105 with the word lines 106b, to constitute the bipolar transistors serving as the current control elements. The memory array is formed such that variable resistive elements 113 are arranged so as to be connected to the bipolar transistors in series so that bit lines 117 are drawn from the variable resistive elements 113 through contacts 116. That is, the emitter of the bipolar transistor Qc is formed on the source line 105 at the intersection with the word line 106b, and the base of the bipolar transistor Qc is formed on the word line 106b at the intersection with the source line 105 and a contact face between the source line 105 and the word line 106b at the intersection forms a junction between the base and the emitter of the bipolar transistor.

Thus, when the memory cell Mc comprising a series circuit of the bipolar transistor Qc and the variable resistive element Rc is arranged in the perpendicular direction at each intersection of the word line W1 or W2 with the bit line B1 or B2, a considerably large degree of miniaturization can be implemented.

In addition, a row decoder which selects a word line connected to a selected memory cell for predetermined memory operations (a programming operation, a resetting operation, a reading operation and the like to be described below) and applies a voltage necessary for the predetermined memory operation and a word line drive circuit are connected to each word line W1 or W2, and a column decoder which selects a bit line connected to the memory cell selected for the predetermined memory operation and applies a voltage necessary for the predetermined memory operation and a bit line drive circuit are connected to each bit line B1 or B2 although they are not shown. In addition, a readout circuit for reading data of the selected memory cell through the selected bit line is provided. Thus, the semiconductor memory device according to the present invention is constituted. Since the row decoder, the word line drive circuit, the column decoder, the bit line drive circuit and the readout circuit can be constituted by using the well-known circuits used in a general nonvolatile semiconductor memory device, a detailed description thereof is omitted.

Next, the memory operations in the thus-constituted memory array will be described. The description is made in a case where the resistance value of the variable resistive element Rc before data is programmed is high such as about 1 MΩ and a potential difference to be applied to the variable resistive element Rc which is required to vary the resistance value of the variable resistive element Rc is about 1.8 V

### (Programming operation)

Referring to Fig. 1, a description will be made of the programming operation to the memory cell according to the present invention (data is programmed by reducing the resistance value of the variable resistive element Rc in the memory cell Mc). When the memory array is not active (in a precharge state), 0 V (GND level) is applied to all of the bit lines, word lines and source lines.

For example, 5 V is applied to the bit line B2 connected to the variable resistive element Rc in the selected memory cell Mc, and 0 V is applied to the other bit line B1. In addition, 0 V is applied to the source line S2 which corresponds to the emitter of the bipolar transistor Qc. Furthermore, when for example, 0.5 V is applied to the word line W2 connected to the base of the bipolar transistor Qc of the memory cell Mc to be accessed, the junction between the emitter and the base becomes a forward bias state and the junction between the base and the collector becomes a reverse bias state. That is, a signal (collector current) amplified by a signal having a relatively small amplitude (base current) applied from the word line W2 is introduced. As a result, if a voltage drop between the emitter and the collector because of internal resistance is 3 V, a current flows from the variable resistive element Rc to the selection transistor Qc, so that a potential difference of 2 V can be generated between both ends of the variable resistive element Rc. That is, the resistance value of the variable resistive element Rc is reduced from about 1 MΩ to several hundred ofΩ. In addition, 0 V is applied to the source line S1 and the word line W1 connected to the non-selected memory cell so that the selected transistor is not conductive. Thus, by the above series of operations, data is programmed in the selected memory cell Mc only.

As described above, by setting each potential, error programming (programming disturbance) in the memory cell adjacent to the selected memory cell Mc can be prevented.

### (Resetting operation (1))

When the memory array is not active (in a precharge state), 0 V (GND level) is applied to all of the bit lines, word lines and source lines like in the programming operation. In order to reset the resistance value of the variable resistive element Rc in the selected memory cell Mc, 0 V, for example is applied to the bit line B2 connected to the variable resistive element Rc of the selected memory cell Mc, and 5 V is applied to the other bit line B1. In addition, 5 V is applied to the source line S2 corresponding to the emitter of the bipolar transistor Qc and to the non-selected source line S1. In addition, 0.5 V, for example is applied to the word line W2 connected to the base of the bipolar transistor Qc of the memory cell Mc to be accessed, so that there is provided a bias state in which the emitter and the collector are replaced in the voltage application state for the programming operation. As a result, if a voltage drop between the emitter and the collector because of the internal resistance is 3 V, a current flows from the selected transistor to the variable resistive element Rc and there is generated a potential difference of 2 V whose polarity is opposite to the programming operation between both ends of the variable resistive element Rc. That is, the resistance value of the variable resistive element Rc rises from several hundred of Ω to about 1 MΩ. In addition, 0 V is applied to the word line W1 connected to the non-selected memory cell so that the selected transistor is not conductive. Thus, by the above series of operations, the reset of programming data in the selected memory cell Mc only can be operated.

### (Resetting operation (2))

When the memory array is not active (in a precharge state), 0 V (GND level) is applied to all of the bit lines, word lines and source lines like in the programming operation. In order to reset the resistance values of the variable resistive elements Rc in the plurality of memory cells connected to the selected word line W2, for example, 0 V is applied to the bit line B2 connected to the variable resistive elements Rc of the selected memory cells Mc, and 0 V is applied to the other bit line B1. The source lines S1 and S2 corresponding to the emitters of the bipolar transistors Qc are opened and the junction between the base and the collector becomes the forward bias state by applying 5 V, for example to the word line W2. As a result, a current flows from the selected transistor Qc to the variable resistive element Rc and there is generated a potential difference of 2 V or more whose polarity is opposite to the programming operation between both ends of the variable resistive element Rc. That is, the resistance value of the variable resistive element Rc rises from several hundred of Ω to about 1 MΩ. In addition, 0 V is applied to the word line W1 connected to the non-selected memory cell so that the selected transistor is not conductive. Thus, by the above series of operations, the data is reset in the plurality of memory cells connected to the selected word line W2.

Since a current does not flow in the high-resistance element of about 1 MΩ which is an initial (reset) state but a current flows in the low-resistance element of several hundred of Ω which is in a selectively programming state in the plurality of memory cells connected to the selected word line W2, the reset operation can be effectively performed.

The memory cells connected to the bit line B1 becomes a non-selected state by applying 5 V to the bit line B1, so that the reset operation by bit unit can be performed only for the selected memory cell Mc.

In addition, since the current mainly flows in the low-resistance elements in the reset operation, power consumption can be reduced. Furthermore, since capacity of a memory cell block which can perform the reset operation at the same time can be considerably increased, a reset operation speed is improved.

### (Reading operation)

When the memory array is not active (in a precharge state), 0 V (GND level) is applied to all of the bit lines, word lines, and source lines like in the programming operation.

Then, 0 V is applied to the source line S2 connected to the selected memory cell Mc and 3 V is applied to the bit line B2, for example. Then, 0.05 V is applied only to the word line W2 connected to the base of the selection transistor Qc of the selected memory cell Mc. At this time, only a potential difference of about 1 to 1.5 V is generated between both ends of the variable resistive element Rc of the selected memory cell Mc, so that the resistance value is not varied.

In addition, 0 V is kept applied to the other word line from the precharge state. In addition, 0 V is supplied to all bit lines except for the bit line B2 connected to the selected memory cell Mc. Thus, a potential difference is not generated between both ends of the variable resistive element Rc of the non-selected memory cell, so that the resistance value is not varied.

As a result, a current path in which a current flows from the bit line B2 to the source line S2 through the selected memory cell Mc to carry out the reading operation. At this time, since the current corresponding to the resistance value of the variable resistive element Rc flows, information "1" or "0" can be determined. That is, it is determined whether data stored in the memory cell Mc is "1" or "0" to carry out the reading operation.

In addition, in the current path of the memory cell Mc, as a ratio of resistance of the variable resistive element Rc to entire resistance of the current path is greater, reading performance is more improved.

Each of the column decoder and the row decoder (not shown) generates a signal for selecting the memory cell and these are provided in the vicinity of the memory array. The column decoder is connected to the bit line and the row decoder is connected to the word line. In addition, the bit lines B1 and B2 are for reading the information stored in the memory cell and they are connected to the readout circuit through the memory cell and the bit line. In addition, the readout circuit is arranged in the vicinity of the memory array.

Next, a description will be made of a manufacturing method of the semiconductor memory device according to the present invention and an embodiment of the semiconductor memory device manufactured by that method with reference to the drawings.

### <Embodiment 1>

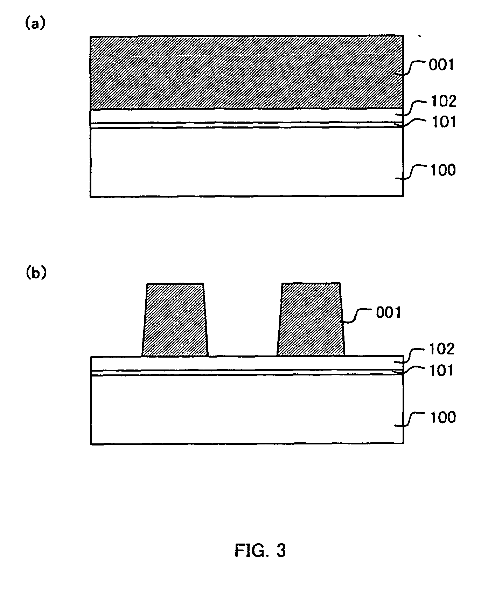

A description will be made of an embodiment of a semiconductor memory device in which a second semiconductor layer and a third semiconductor layer which will be described below are formed of epitaxial silicon films with reference to Figs. 3 to 17. In each figure, (a) is a sectional view taken along line A-A and (b) is a sectional view taken along line B-B in the memory array shown in Fig. 2.

First, a silicon oxide film 101 serving as a mask layer is deposited 10 to 100 nm in thickness on a surface of a p-type silicon substrate 100, for example serving as a semiconductor substrate. Then, a silicon nitride film 102 is deposited 50 to 500 nm in thickness, and the silicon nitride film 102 and the silicon oxide film 101 are sequentially etched away by reactive ion etching by using a first resist mask 001 patterned by the well-known photolithography as a mask (refer to Fig. 3).

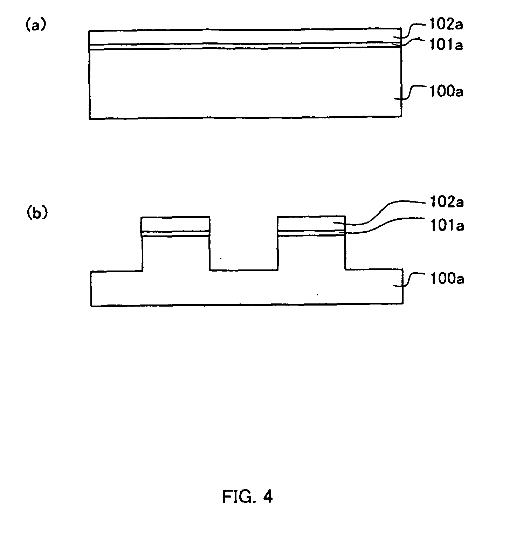

Then, a p-type silicon substrate 100a comprising a striped grooves having a depth of 100 nm to 1000 nm in the p-type silicon substrate 100 is formed using a silicon nitride film 102a and a silicon oxide film 101a which are patterned in the form of stripe as masks (refer to Fig. 4). At this time, the above mentioned groove may be formed using the resist mask 001 as the mask.

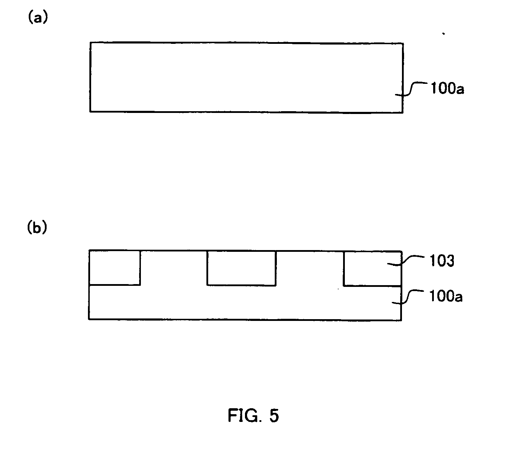

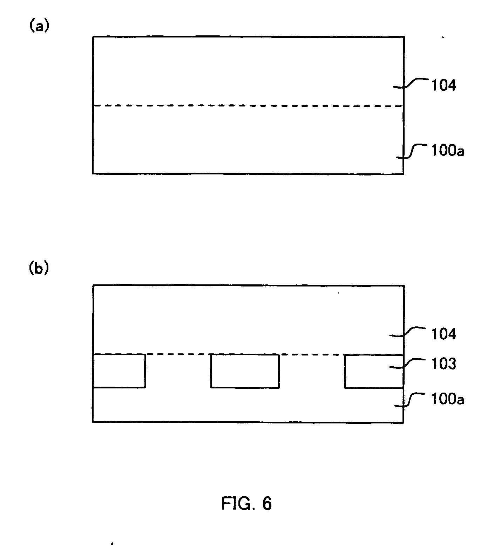

Then, for example a silicon oxide film 103 is buried in the groove as an insulation film serving as an element isolation region using CMP (Chemical Mechanical Polishing) and the like (refer to Fig. 5). Then, a p-type epitaxial silicon layer 104 is deposited 1 µm to 10 µm in thickness on the surface of the p-type silicon substrate 100a and the silicon oxide film 103, for example. At this time, an impurity volume concentration of the epitaxial silicon is preferably about 10¹⁵ to 10¹⁸ /cm³ (refer to Fig. 6).

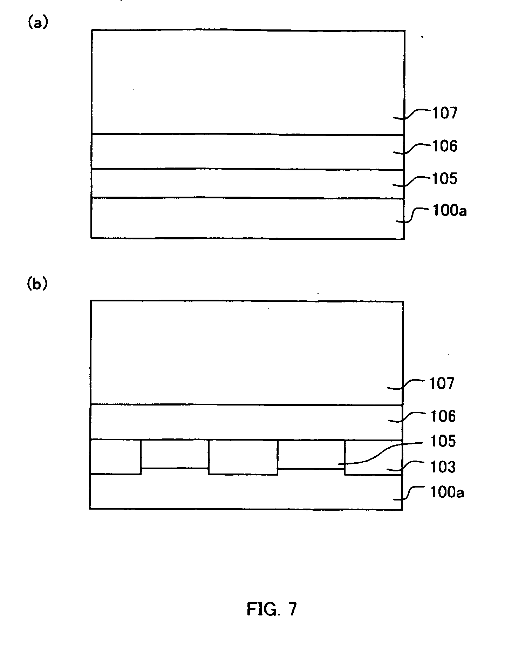

Then, a first semiconductor layer (corresponding to the source line and the emitter of the selection transistor) 105 formed of an n-type silicon impurity layer is formed between the silicon oxide films 103 provided in the groove of the p-type silicon substrate 100a, using ion implantation, for example. At this time, an impurity volume concentration of the n-type first semiconductor layer 105 is preferably about 10¹⁶ to 10²⁰ /cm³. Then, a second semiconductor layer of a p-type silicon impurity layer (which becomes the word line and the base of the selection transistor after patterning) 106 and a third semiconductor layer of the n-type silicon impurity layer (which becomes the collector of the selection transistor after patterning) 107 are formed on the first semiconductor layer 105 using ion implantation and the like (refer to Fig. 7). At this time, it is desirable that an impurity volume concentration of the p-type second semiconductor layer 106 is about 10¹⁶ to 10¹⁹ /cm³ and an impurity volume concentration of the n-type third semiconductor layer 107 is about 10¹⁶ to 10²⁰ /cm³. Impurity concentration profiles of the first to third semiconductor layers 105, 106 and 107 may be any introduction order if they are appropriately set so as to take optimal profiles to target voltage specification of the bipolar transistor of the memory cell. In addition, since the third semiconductor layer 107 is etched back for depositing a variable resistive element film 113 by self-aligning to be described below, its film thickness is reduced. Therefore, an initial film thickness of the third semiconductor layer 107 is set so as to be not less than a thickness provided by adding its final thickness and a final film thickness of the variable resistive element film 113. However, the impurity concentration profile of the third semiconductor layer 107 may be provided so as to conform to the final film thickness.

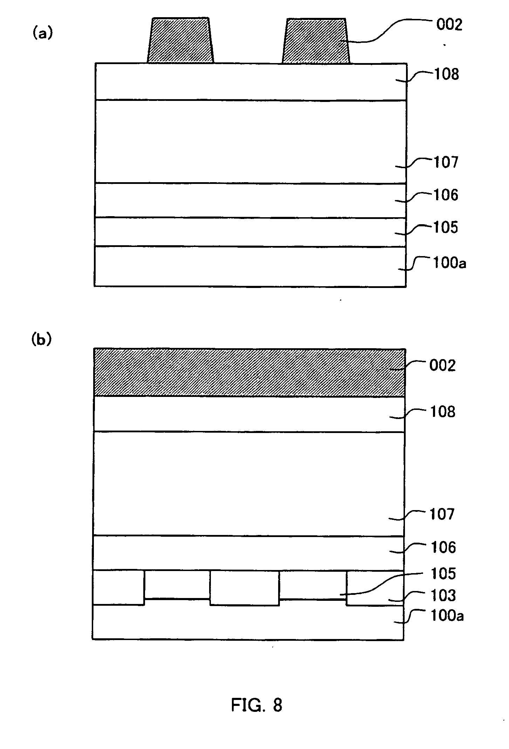

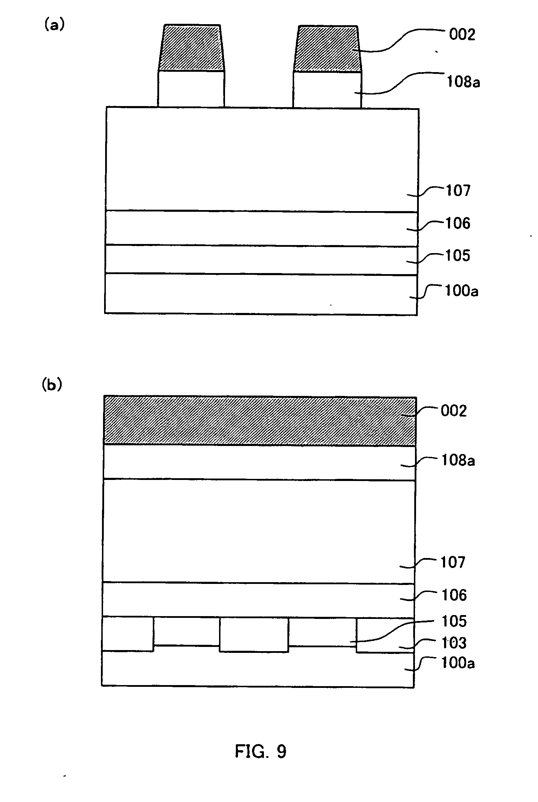

Then, for example, a silicon nitride film 108 serving as a mask layer is deposited 100 to 1000 nm in thickness on the epitaxial silicon surface and etched away in the form of stripe by reactive ion etching (refer to Fig. 9), using a second resist mask 002 patterned by the well-known photolithography as a mask (refer to Fig. 8).

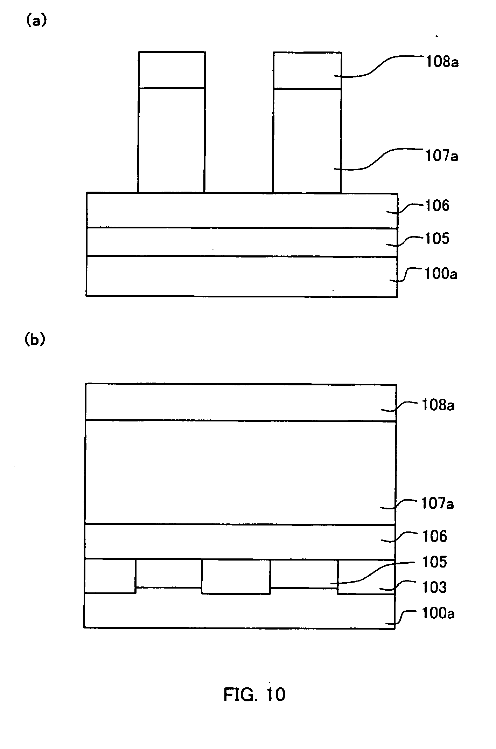

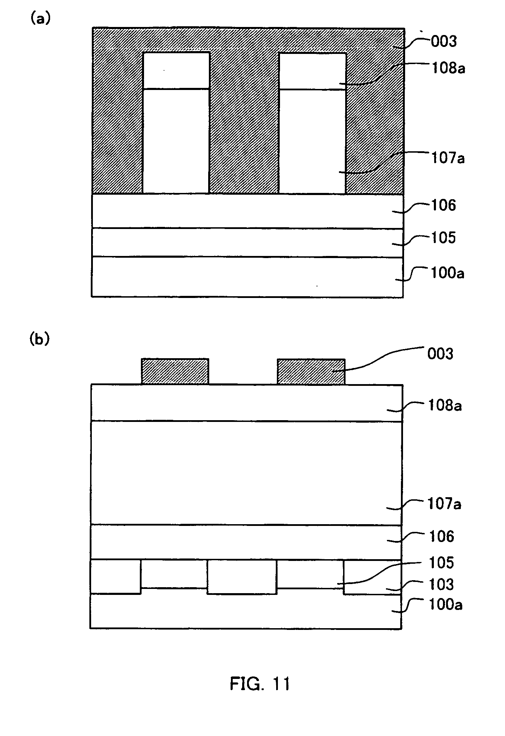

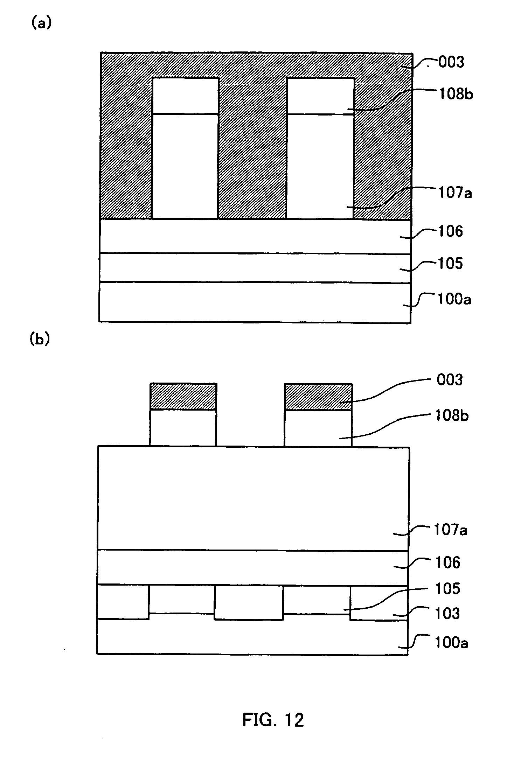

Then, a part of the third semiconductor layer 107 comprising the epitaxial layer is selectively etched away to form striped grooves (refer to Fig. 10, in which a third semiconductor layer 107a is provided after etching) using the silicon nitride film 108a which is patterned in the shape of stripe as a mask. Its etching amount is set at a thickness of the third semiconductor layer 107 (in the depth direction) or more. Then, the silicon nitride film 108a is selectively etched away (refer to Fig. 12) by reactive ion etching, using a third resist mask 003 patterned by the well-known photolithography as a mask (refer to Fig. 11). As a result, the silicon nitride film 108a is formed in the form of islands above each intersection of the word lines with the source lines.

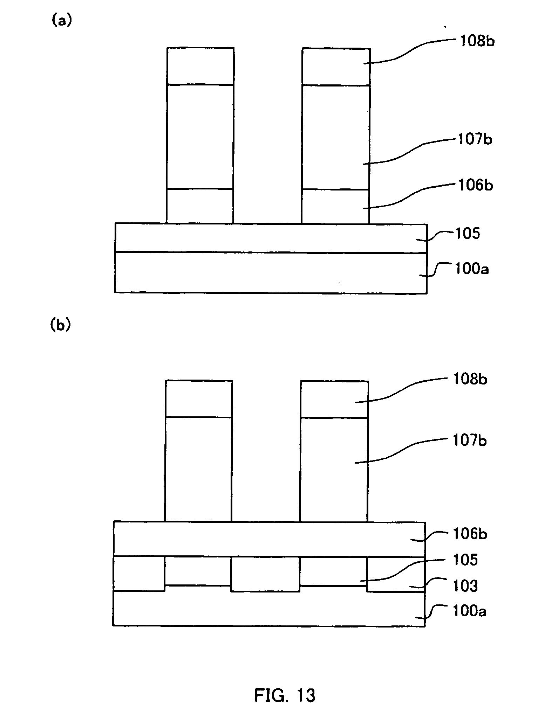

Then, the second semiconductor layer 106 comprising the epitaxial layer and a part of the third semiconductor layer 107a after the first patterning are selectively etched away, using a silicon nitride film 108b as a mask patterned to be the form of islands by the second and third resist mask to form a third semiconductor layer 107b and a second semiconductor layer 106b (refer to Fig. 13). Its etching amount is set at a thickness of the third semiconductor layer 107 or more (in the depth direction). As a result, the second semiconductor layer 106b is patterned so as to be the form of stripe and the word lines are formed, and the third semiconductor layer 107b thereon forms the collector of the bipolar transistor having the same island pattern as of the silicon nitride film 108b.

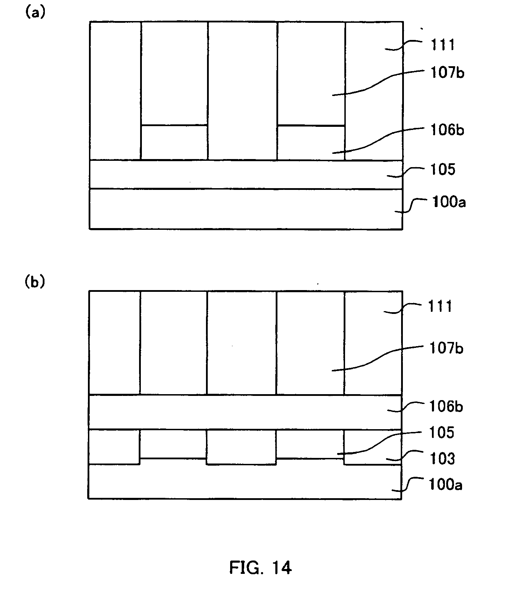

Then, after the silicon nitride film 108b is selectively removed, an insulation film 111 is buried in the groove (around the patterned second semiconductor layer 106b and patterned third semiconductor layer 107b) (refer to Fig. 14). Alternatively, after the insulation film 111 is buried in the groove, the silicon nitride film 108b is selectively removed.

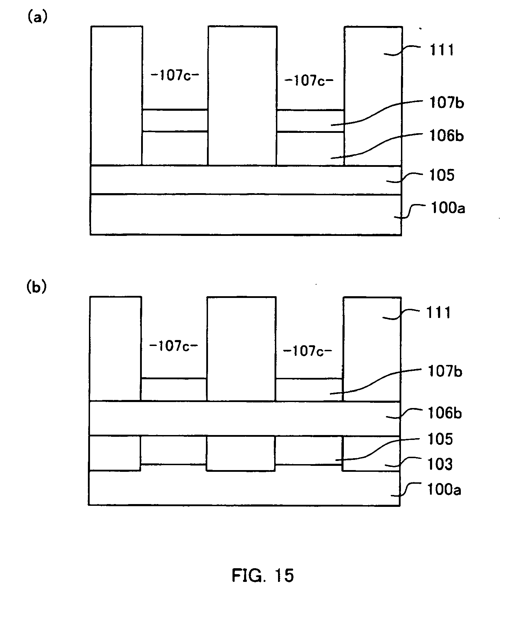

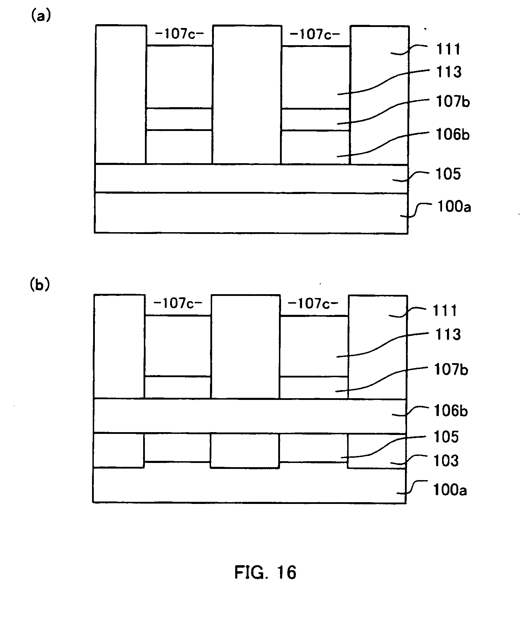

Then, only the patterned third semiconductor layer 107b is selectively etched back and a hole 107c is formed between the insulation films 111 which is not etched away (refer to Fig. 15). Then, a thin film material PCMO and the like is formed on the insulation film 111 and in the hole 107c as a variable resistive element film 113 and then only the variable resistive element film 113 is selectively etched back and the variable resistive element film 113 is formed on the third semiconductor layer 107b in the hole 107c so as to be positioned and patterned by self-aligning (refer to Fig. 16).

Then, the hole 107c on the patterned variable resistive element film 113 is filled with a contact 116 by self-aligning and a metal interconnect (corresponding to the bit line) 117 is formed (refer to Fig. 17). In addition, the contact 116 and the metal interconnect 117 may be formed of the same material and only the metal interconnect may be formed without providing the contact 116. In addition, the contact may be omitted by controlling the etch back of the variable resistive element film 113 so that the film 113 may be the same level as the surface of the insulation film 111.

### <Embodiment 2>

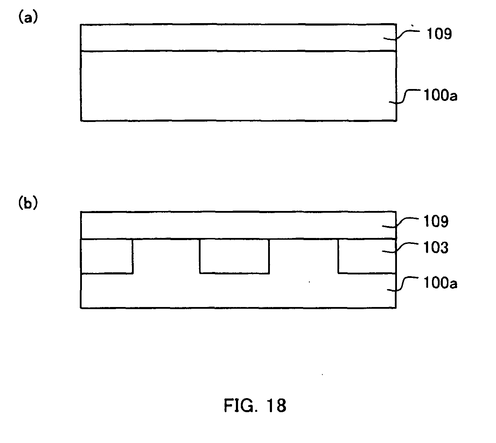

A description will be made of an embodiment 2 of the semiconductor memory device in which a part of a second semiconductor layer is formed of polycrystalline silicon film with reference to Figs. 18 to 21. In each figure, (a) is a sectional view taken along line A-A and (b) is a sectional view taken along line B-B in the memory array shown in Fig. 2. Steps until a silicon oxide film 103, for example is buried in a groove formed by a resist mask 001 as an insulation film (refer to Figs. 3 to 5) are the same as in the embodiment 1.

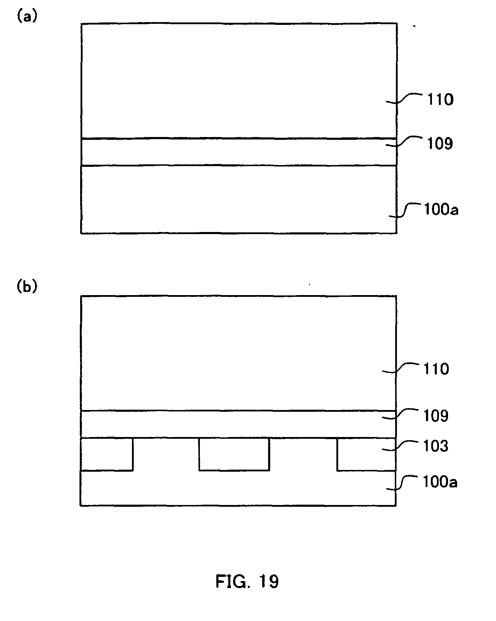

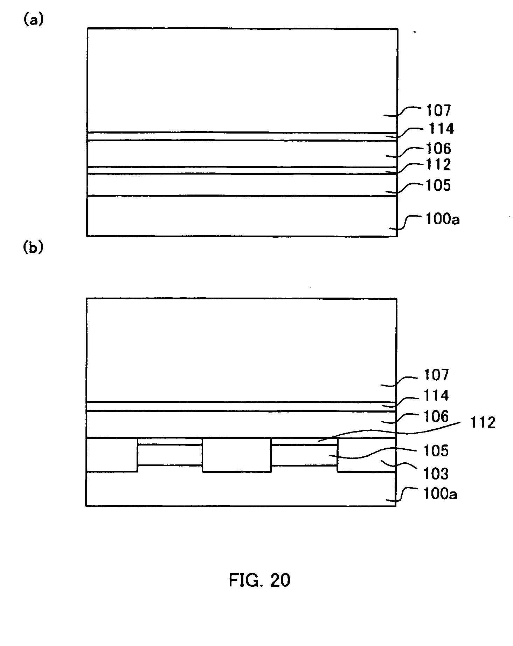

Then, a polycrystalline silicon film 109 is deposited about 100 nm to 5 µm in thickness, for example on a p-type silicon substrate 100a and the silicon oxide film 103 (refer to Fig. 18). Then, a p-type epitaxial silicon layer 110, for example is deposited about 100 nm to 5 µm in thickness on the polycrystalline silicon film 109 (refer to Fig. 19). Then, a first semiconductor layer of an n-type impurity layer (corresponding to the source line and the emitter of the selection transistor) 105 is formed between the silicon oxide films 103 which are buried in the groove in the p-type silicon substrate 100a by the ion implantation, for example. At this time, an impurity volume concentration of the n-type silicon first semiconductor layer 105 is preferably about 10¹⁶ to 10²⁰ /cm³. In addition, a second semiconductor layer of a p-type silicon impurity layer (which becomes the word line and the base of the selection transistor after patterning) is formed on the first semiconductor layer 105 similarly by the ion implantation. A diffusion speed of the p-type impurity implanted in the polycrystalline silicon film 109 is 2 to 100 times as fast as that of a single-crystalline silicon film, and the second semiconductor layer comprises the p-type impurity layer 106 formed in the polycrystalline silicon film 109, a p-type impurity layer 112 formed in the Si substrate 100a and a p-type impurity layer 114 formed in the epitaxial silicon layer 110 (refer to Fig. 20). More specifically, the impurity layer 112 and the impurity layer 114 are formed by diffusion from the polycrystalline silicon film 109 into the single-crystalline silicon film and they are placed apart from the polycrystalline silicon film 109 at a predetermined distance. That is, a thickness of the second semiconductor layer (a thickness of the word line and a base width of the selection transistor) is set at a film thickness of the polycrystalline silicon film 109. At this time, an impurity volume concentration of the p-type impurity layer 106 is preferably about 10¹⁶ to 10¹⁹ /cm³.

Then, a third semiconductor layer of an n-type silicon impurity layer (which becomes the collector of the selection transistor after patterning) 107 is similarly formed by the ion implantation. At this time, an impurity volume concentration of the n-type third semiconductor layer 107 is preferably about 10¹⁶ to 10²⁰ /cm³. Impurity concentration profiles of the first to third semiconductor layers 105, 106 and 107 may be any introduction order if they are appropriately set so as to take optimal profiles for a target voltage specification of the bipolar transistor of the memory cell. Since a junction between the p-type impurity layer 112 and the n-type first semiconductor layer 105 (the junction between the emitter and the base) and a junction between the p-type impurity layer 114 and the n-type third semiconductor layer 107 (the junction between the collector and the base) are formed in the single-crystalline silicon film, a junction leak current is prevented.

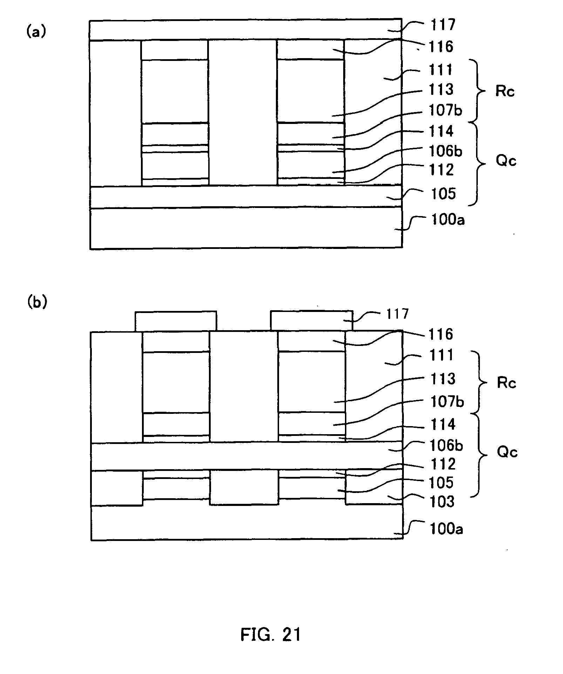

Steps after the impurities are implanted are the same as those of the embodiment 1 (refer to Figs. 8 to 17). Fig. 21 shows a sectional view after a metal interconnect (bit line) is formed (corresponding to Fig. 17 in the embodiment 1).

### <Embodiment 3>

An embodiment 3 in which a variable resistive element film 113 is formed without depending on the self-aligning will be described. According to this embodiment, steps until an insulation film 111 is buried around a second semiconductor layer 106b and a third semiconductor layer 107b after patterned are the same as those in the embodiment 1 basically. However, since the patterned third semiconductor layer 107b is not etched back in this embodiment unlike the embodiment 1, an initial film thickness of the third semiconductor layer 107 is set thinner than that of the embodiment 1 by the amount of the etch back.

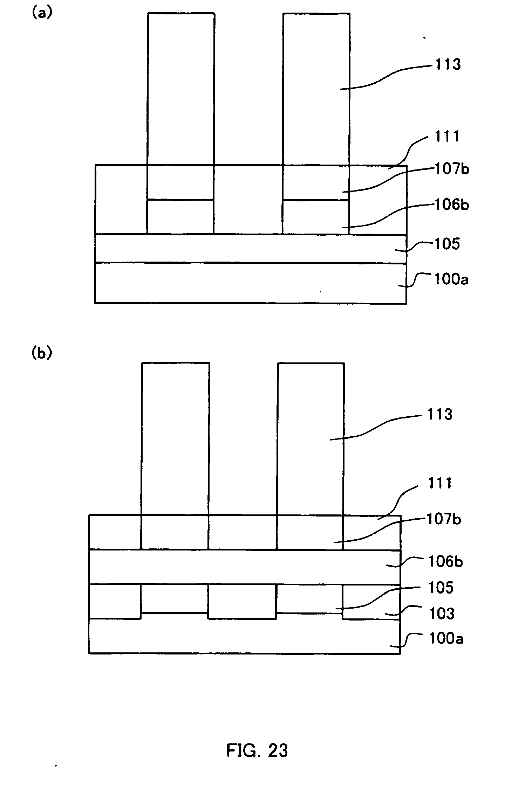

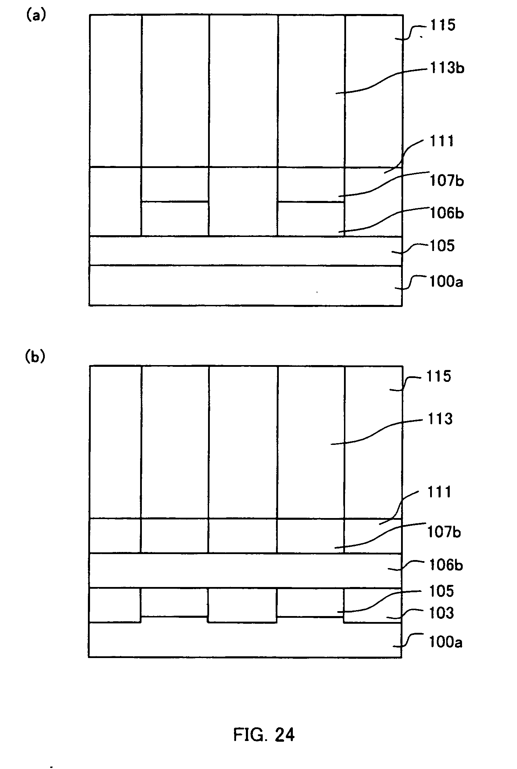

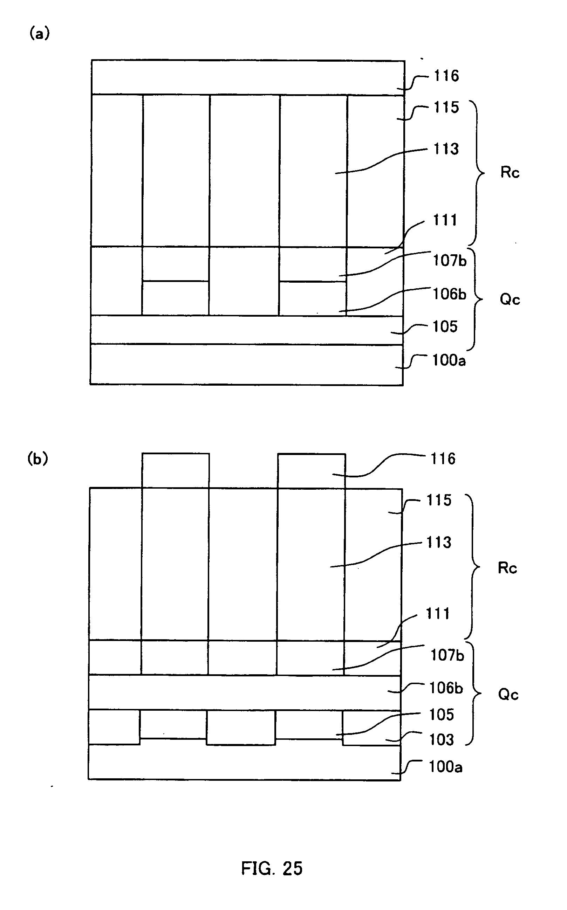

After the insulation film 111 is buried and a silicon nitride film 108b is removed, a thin film material of PCMO and the like is deposited as a variable resistive element film 113 on the surface of the insulation film 111 and the third semiconductor layer 107b, and the variable resistive element film 113 is etched away by the reactive ion etching so as to form an island-shaped variable resistive element on the third semiconductor layer 107b, using a fourth resist mask patterned by the well-known photolithography as a mask (refer to Fig. 23). Then, a silicon oxide film 115, for example is buried as an insulation film between the variable resistive elements (refer to Fig. 24). Then, a metal interconnect (corresponding to a bit line) 117 is formed on the patterned variable resistive element film 113 by the well-known technique (refer to Fig. 25).

In each of the above embodiments, the second semiconductor layer 106 and the third semiconductor layer 107 may be formed in the single-crystalline silicon instead of formed in the epitaxial silicon layer 104.

Furthermore, although the thin film material of a perovskite structure is used as the variable resistive element material of the memory cell according to the present invention, the present invention can be applied to a memory cell comprising a variable resistive element formed of another variable resistive element material.

In addition, although the 2 x 2 array is used in describing the memory array in which the memory cells are arranged in the form of a matrix according to the present invention in Fig. 1 to simplify the description, a memory array is not limited to a particular size.

As described above, according to the present invention, the programming operation, the resetting operation and reading operation can be performed by random access (by each bit) with the nonvolatile semiconductor memory device, by constituting the memory cell in which a memory element using a thin film material of the perovskite structure as the variable resistive element and the selection transistor are connected in series by the self-aligning, and constituting the memory array in which the memory cells are arranged in the form of the matrix, and setting the word line, the bit line and the source line at the above potential. In addition, a page deletion by each word line can be performed depending on a voltage application pattern to each control line (the word line and the like). Especially, the structure of the memory cells in series can be easily implemented by comprising the bipolar transistor as the selection transistor.

In addition, there can be provided memory cells which can be operated at a low voltage and highly integrated, and a semiconductor memory device using such memory cells. Furthermore, since the circuit is so constituted that a leak current to the adjacent memory cell is prevented from being generated when the memory cell is accessed, there can be provided an effective memory device with high reliability. Still further, each of the programming operation, the resetting operation and the reading operation can be performed at a high speed.

Furthermore, since the base width can be set at the film thickness of the polycrystalline silicon film when the second semiconductor layer which is the word line of the selection transistor comprising the bipolar transistor comprises the polycrystalline silicon film, the selection transistor can be easily designed.

## Claims

1. A memory cell (M_{c}) comprising:
a variable resistive element (R_{c}); and a selection transistor comprising a bipolar transistor (Q_{c}) which can control a current flowing in the variable resistive element bi-directionally, **characterised in that**
an upper electrode (107b) of either a collector or an emitter of the bipolar transistor is stacked on a base (106b) of the bipolar transistor and the variable resistive element (113) is stacked on the upper electrode of the bipolar transistor to be connected to the upper electrode of the bipolar transistor,
one of two parallel sidewall surfaces of the base of the bipolar transistor, one of two parallel sidewall surfaces of the upper electrode of the bipolar transistor and one of two parallel sidewall surfaces of the variable resistive element are aligned with each other to form a vertical surface, and
the other of the two parallel sidewall surfaces of the base of the bipolar transistor, the other of the two parallel sidewall surfaces of the upper electrode of the bipolar transistor and the other of the two parallel sidewall surfaces of the variable resistive element are aligned with each other to form another vertical surface.

2. A semiconductor memory device comprising:
a memory array on a semiconductor substrate having a constitution such that a plurality of memory cells according to claim 1 in which one end of the variable resistive element is connected to either the emitter or the collector of the bipolar transistor are arranged in the row direction and the column direction in the form of a matrix, a base of the bipolar transistor in each memory cell in the same row is connected to a common word line extending in the row direction, and the other end of the variable resistive element in each memory cell in the same column is connected to a common bit line extending in the column direction, **characterized in that**
the other of the emitter or the collector of the bipolar transistor in each memory cell in the same column is connected to a common source line extending in the column direction.

3. The semiconductor memory device according to claim 2, **characterized in that**
the source line is formed on the semiconductor substrate as a striped p-type or n-type semiconductor layer, the word line is formed on the source line as a striped semiconductor layer whose conductive type is different from that of the source line, a junction between the base and the emitter or a junction between the base and the collector of the bipolar transistor in each memory cell is formed on a contact face between the source line and the word line where the source line intersects with the word line.

4. The semiconductor memory device according to claim 3, **characterized in that**
either the emitter or the collector of the bipolar transistor connected to one end of the variable resistive element in each memory cell is formed of a semiconductor layer, having the same conductivity type as the source line, on the word line where the source line intersects with the word line, and
the variable resistive element in each memory cell is formed on either the emitter or the collector of the bipolar transistor connected to the one end of the variable resistive element at each intersection of the source line with the word line, and the bit line is formed on the variable resistive element.

5. The semiconductor memory device according to claim 4, **characterized in that**
the bit line comprising a contact which electrically comes in contact with the variable resistive element is connected to the variable resistive element,
one of two parallel sidewall surfaces of the contact and one of two parallel sidewall surfaces of the variable resistive element are aligned with each other to form a vertical surface, and
the other of the two parallel sidewall surfaces of the contact and the other of the two parallel sidewall surfaces of the variable resistive element are aligned with each other to form another vertical surface.

6. The semiconductor memory device according to claim 4, **characterized in that**
one of two parallel sidewall surfaces of the bit line and one of two parallel sidewall surfaces of the variable resistive element are aligned with each other to form a vertical surface, and
the other of the two parallel sidewall surfaces of the bit line and the other of the two parallel sidewall surfaces of the variable resistive element are aligned with each other to form another vertical surface.

7. The semiconductor memory device according to claim 2, **characterized in that**
each electrode of the bipolar transistor and the variable resistive element are laminated perpendicularly to a semiconductor substrate.

8. The semiconductor memory device according to claim 2, **characterized in that**
the variable resistive element is a memory element in which a resistance value is changed reversibly by voltage application.

9. The semiconductor memory device according to claim 2, **characterized in that**
a material of the variable resistive element is an oxide material of a perovskite structure containing manganese.

10. A method of manufacturing the semiconductor memory device according to claim 2, **characterized by** comprising:
a step of forming an element isolation region on the semiconductor substrate;
a step of forming a first semiconductor layer (105) serving as the source line between the element isolation regions;
a step of depositing a second semiconductor layer (106) a part of which becomes the word line and a third semiconductor layer (107) a part of which becomes either one of an emitter or a collector of the bipolar transistor connected to one end of the variable resistive element, on the first semiconductor layer and the element isolation region;
a step of patterning a part of the third semiconductor layer;
a step of patterning another part of the third semiconductor layer and the second semiconductor layer; and
a step of forming the variable resistive element on the third semiconductor layer after having been patterned two times.

11. The method of manufacturing the semiconductor memory device according to claim 10, **characterized in that**
at least one part of the second semiconductor layer comprises a polycrystalline silicon film.

12. The method of manufacturing the semiconductor memory device according to claim 10, **characterized in that**
an upper part of the second semiconductor layer and the third semiconductor layer comprise an epitaxial silicon film.

13. The method of manufacturing the semiconductor memory device according to claim 10, **characterized in that**
the second semiconductor layer and the third semiconductor layer comprise an epitaxial silicon film.

14. The method of manufacturing the semiconductor memory device according to claim 10, **characterized by** comprising
a step of implanting an impurity in each semiconductor layer by impurity ion implantation after the first semiconductor layer, the second semiconductor layer and the third semiconductor layer are deposited.

15. The method of manufacturing the semiconductor memory device according to claim 10, **characterized in that**
the source line is patterned by a first photoresist mask, the word line is patterned by a second photoresist mask, and either the emitter or the collector of the bipolar transistor connected to the one end of the variable resistive element is patterned by the second photoresist mask and a third photoresist mask.

16. The method of manufacturing the semiconductor memory device according to claim 10, **characterized in that**
a hole is formed in an insulation film formed around the third semiconductor layer by etching back the third semiconductor layer after having been patterned two times, the variable resistive element is deposited in the hole, and the variable resistive element and the third semiconductor layer are connected by self-aligning.

17. The method of manufacturing the semiconductor memory device according to claim 16, **characterized in that**
an upper face of the variable resistive element deposited in the hole is positioned lower than an upper face of the insulation film formed around the third semiconductor layer by etching back.

## Patentansprüche

1. Speicherzelle (Mc) mit:
einem variablen resistiven Element (Rc); und einem Auswahltransistor mit einem Bipolartransistor (Qc), der einen in dem variablen resistiven Element fließenden Strom bidirektional steuern kann, **dadurch gekennzeichnet, dass**
eine obere Elektrode (107b) entweder eines Kollektors oder eines Emitters des Bipolartransistors auf einer Basis (106b) des Bipolartransistors aufgeschichtet ist und das variable resistive Element (113) auf der oberen Elektrode des Bipolartransistors aufgeschichtet ist, um mit der oberen Elektrode des Bipolartransistors verbunden zu sein,
eine von zwei parallelen Seitenwand-Oberflächen der Basis des Bipolartransistors, eine von zwei parallelen Seitenwand-Oberflächen der oberen Elektrode des Bipolartransistors und eine von zwei parallelen Seitenwand-Oberflächen des variablen resistiven Elements so aneinander ausgerichtet sind, dass sie eine vertikale Oberfläche bilden, und
die andere der beiden parallelen Seitenwand-Oberflächen der Basis des Bipolartransistors, die andere der beiden parallelen Seitenwand-Oberflächen der oberen Elektrode des Bipolartransistors und die andere der beiden parallelen Seltenwand-Oberflächen des variablen resistiven Elements so aneinander ausgerichtet sind, dass sie eine andere vertikale Oberfläche bilden.

2. Halbleiterspeicherbauclement mit:
einem Speicher-Array auf einem Halbleitersubstrat mit einer derartigen Beschaffenheit, dass eine Mehrzahl von Speicherzellen nach Anspruch 1, in denen ein Ende des variablen resistiven Elements entweder mit dem Emitter oder dem Kollektor des Bipolartransistors verbunden ist, in der Richtung der Zeilen und der Richtung der Spalten in einer Matrix-Form angeordnet ist, eine Basis des Bipolartransistors in jeder Speicherzelle in derselben Zeile mit einer gemeinsamen Wortleitung verbunden ist, die sich in die Richtung der Zeilen erstreckt, und das andere Ende des variablen resistiven Elements in jeder Speicherzelle in derselben Spalte mit einer gemeinsamen Bitleitung verbunden ist, die sich in der Richtung der Spalten erstreckt, **dadurch gekennzeichnet, dass**
der Emitter oder der Kollektor, mit dem das resistive Element nicht verbunden ist, in jeder Speicherzelle in derselben Spalte mit einer gemeinsamen Source-Leitung verbunden ist, die sich in der Richtung der Spalten erstreckt.

3. Halbleiterspeicherbauelement nach Anspruch 2, **dadurch gekennzeichnet, dass**
die Source-Leitung auf dem Halbleitersubstrat als eine gestreifte p-Typ oder n-Typ Halbleiterschicht gebildet ist, die Wortleitung auf der Source-Leitung als eine gestreifte Halblelterschicht gebildet ist, deren Leitungstyp ein anderer als der der Source-Leitung ist, eine Verbindungsstelle zwischen der Basis und dem Emitter oder eine Verbindungsstelle zwischen der Basis und dem Kollektor des Bipolartransistors In jeder Speicherzelle auf einer Kontaktfläche zwischen der Source-Leitung und der Wortleitung gebildet ist, wo die Source-Leitung die Wortleitung kreuzt.

4. Halbleiterspeicherbauelement nach Anspruch 3, **dadurch gekennzeichnet, dass**
entweder der Emitter oder der Kollektor des mit einem Ende des variable resistiven Elements in jeder Speicherzelle verbundenen Bipolartransistors aus einer Halbleiterschicht vom gleichen Leitungstyp wie die Source-Leitung auf der Wortleitung gebildet ist, wo die Source-Leitung die Wortleitung kreuzt, und
das variable resistive Element in jeder Speicherzelle entweder auf dem Emitter oder dem Kollektor des an jeder Kreuzungsstelle der Source-Leitung mit der Wortleitung mit dem einen Ende des variablen resistiven Elements verbundenen Bipolartransistors gebildet ist und die Bilteitung auf dem variablen resistiven Element gebildet ist.

5. Halbleiterspeicherbauelement nach Anspruch 4, **dadurch gekennzeichnet, dass**
die einen mit dem variablen resistiven Element elektrisch in Verbindung tretenden Kontakt aufweisende Bitleitung mit dem variablen resistiven Element verbunden ist,
eine von zwei parallelen Seitenwand-Oberflächen des Kontakts und eine von zwei parallelen Seitenwand-Oberflächen des variablen resistiven Elements aneinander ausgerichtet sind, um eine vertikale Fläche zu bilden, und
die andere der beiden parallelen Seitenwand-Oberflächen des Kontakts und die andere der beiden parallelen Seitenwand-Oberflächen des variablen resistiven Elements aneinander ausgerichtet sind, um eine weitere vertikale Fläche zu bilden.

6. Halbleiterspelcherbauelemenl nach Anspruch 4, **dadurch gekennzeichnet, dass**
eine von zwei parallelen Seitenwand-Oberflächen der Bitleitung und eine von zwei parallelen Seitenwand-Oberflächen des variablen resistiven Elements aneinander ausgerichtet sind, um eine vertikale Oberfläche zu bilden, und
die andere der beiden parallelen Seitenwand-Oberflächen der Bitleitung und die andere der beiden parallelen Seitenwand-Oberflächen des variablen resistive Elements aneinander ausgerichtet sind, um eine weitere vertikale Oberfläche zu bilden.

7. Halbleiterspeicherbauelement nach Anspruch 2, **dadurch gekennzeichnet, dass** jede Elektrode des Bipolartransistors und das variable Element senkrecht zu einem Halbleitersubstrat aufgeschichtet sind.

8. Halbleiter speicherbauelement nach Anspruch 2, **dadurch gekennzeichnet, dass** das variable resistive Element ein Speiclierbauelement ist, in welchem ein Widerstandswert durch ein Anlegen einer Spannung reversibel verändern wird.

9. Halbleiterspeicherbauclement nach Anspruch 2, **dadurch gekennzeichnet, dass** ein Material des variablen resistiven Elements ein Oxidmaterial mit einer Mangan aufweisenden Perowskit-Struktur ist.

10. Verfahren zum Herstellen des Halbleiterspelcherbauelements nach Anspruch 2, **gekennzeichnet durch**:
einen Schritt zum Bilden einer Bauelement-Isolationsregion (103) auf dem Halbleitersubstrat (100);
einen Schritt zum Bilden einer als die Source-Leitung dienenden ersten Halbleiterschicht (105) zwischen den Bauclement-Isolationsregionen;
einen Schritt zum Abscheiden einer zweiten Halbleiterschicht (106), von der ein Teil zu der Wortleitung wird, und einer dritten Halbleiterschicht (107), von der ein Teil entweder zu einem Emitter oder einem Kollektor des mit einem Ende des variablen resisitven Elements verbundenen Bipolartransistors wird, auf der ersten Halbleiterschicht und der Bauelement-Isolationsregion;
einen Schritt zum Formen eines Teils der dritten Halbleiterschicht;
einen Schritt zum Formen eines weiteren Teils der dritten Halbleiterschicht und der zweiten Halbeiterschicht; und
einen Schritt zum Formen des variablen resistiven Elements auf der dritten Halbleiterschicht, nach einem zweimaligen Formen.

11. Verfahren zum Herstellen des Halbleiterspeicherbauelements gemäß Anspruch 10, **dadurch gekennzeichnet, dass** wenigstens ein Teil der zweiten Halbleiterschicht einen polykristallinen Siliziumfilm aufweist.

12. Verfahren zum Herstellen des Halbleiterspeicherbauelements gemäß Anspruch 10, **dadurch gekennzeichnet, dass** ein oberer Teil der zweiten Halbleiterschicht und die dritte Halbleiterschicht eine epitaktische Siliziumschicht aufweisen.

13. Verfahren zum Herstellen des Halbleiterspeicherbeuelements gemäß Anspruch 10, **dadurch gekennzeichnet, dass** die zweite Halbleiterschicht und die dritte Halbleiterschicht eine epitaktische Siliziumschicht aufweisen.

14. Verfahren zum Herstellen des Halbleiterspeicherbauelements gemäß Anspruch 10, **gekennzeichnet durch** einen Schritt zum Implantieren einer Störstelle in jeder Halbleiterschicht **durch** eine Sörstellenlonenimplantation, nachdem die erste Halbleiterschicht, die zweite Halbleiterschicht und die dritte Halbleiterschicht abgeschieden sind.

15. Verfahren zum Herstellen des Halbleiterspeicherbauelements gemäß Anspruch 10, **dadurch gekennzeichnet, dass** die Source-Leitung durch eine erste Photolack-Maske geformt wurde, die Wortleitung durch eine zweite Photolack-Maske geformt wurde und entweder der Emitter oder der Kollektor des mit dem einen Ende des variablen resistiven Elements verbundenen Bipolartransistors durch die zweite Photolack-Maske und eine dritte Photolack-Maske geformt wurde.

16. Verfahren zum Herstellen des Halbleiterspeicherbauelements gemäß Anspruch 10, **dadurch gekennzeichnet, dass** ein Loch in einem um die dritte Halbleiterschicht gebildeten Isolationsfilm durch ein Zurückätzen der dritten Halbleiterschicht gebildet wird, nachdem sie zweimal geformt wurde, wobei das variable resistive Element in dem Loch abgeschieden wird und das variable resistive Element und die dritte Halbleiterschicht durch eine Selbstausrichtung verbunden werden.

17. Verfahren zum Herstellen des Halbleiterspeicherbauelements gemäß Anspruch 16, **dadurch gekennzeichnet, dass** eine obere Fläche des in dem Loch abgeschiedenen variablen resistiven Elements tiefer angeordnet ist als eine obere Fläche des um die dritte Halbleiterschicht durch ein Zurückätzen gebildeten Isolationsfilms.

## Revendications

1. Cellule de mémoire (M_{c}) comportant :
un élément résistif variable (R_{c}) ; et un transistor de sélection comportant un transistor bipolaire (Q_{c}) permettant de commander un courant circulant de manière bidirectionnelle dans l'élément résistif variable, **caractérisé en ce**
une électrode supérieure (107b), au choix, d'un collecteur ou d'un émetteur du transistor bipolaire, est superposée sur une base (106b) du transistor bipolaire, et l'élément résistif variable (113) est superposé à l'électrode supérieure du transistor bipolaire pour être relié à l'électrode supérieure du transistor bipolaire,
l'une de deux surfaces de parois parallèles de la base du transistor bipolaire, l'une de deux surfaces de parois parallèles de l'électrode supérieure du transistor bipolaire et l'une de deux surfaces de parois parallèles de l'élément résistif variable sont alignées les unes avec les autres pour former une surface verticale, et
l'autre des deux surfaces de parois parallèles de la base du transistor bipolaire, l'autre des deux surfaces de parois parallèles de l'électrode supérieure du transistor bipolaire et l'autre des deux surfaces de parois parallèles de l'élément résistif variable sont alignées les unes avec les autres pour former une autre surface verticale.

2. Dispositif de mémoire à semi-conducteurs comportant :
une matrice de mémoire placée sur un substrat à semi-conducteurs, possédant une constitution telle que plusieurs cellules de mémoire selon la revendication 1, dans lesquelles une extrémité de l'élément résistif variable est reliée, au choix, à l'émetteur ou au collecteur du transistor bipolaire, sont disposées dans la direction des rangées et dans la direction des colonnes pour former une matrice, une base du transistor bipolaire de chacune des cellules de mémoire d'une même rangée étant reliée à une ligne de mot commune se prolongeant selon la direction des rangées, et l'autre extrémité de l'élément résistif variable de chaque cellule de mémoire d'une même colonne étant reliée à une ligne commune de bit se prolongeant dans la direction des colonnes, **caractérisé en ce que**
l'autre de l'émetteur ou du collecteur du transistor bipolaire de chaque cellule de mémoire d'une même colonne est relié à une ligne commune de source se prolongeant dans la direction des colonnes.

3. Dispositif de mémoire à semi-conducteurs selon la revendication 2, **caractérisé en ce que**
la ligne de source est réalisée sur le substrat à semi-conducteurs sous la forme d'une couche à semi-conducteurs en bande de type P ou de type N, la ligne de mot est réalisée sur la ligne de source sous la forme d'une couche à semi-conducteurs en bande, d'un type de conductivité différent de celui de la ligne de source, une jonction entre la base et l'émetteur ou une jonction entre la base et le collecteur du transistor bipolaire de chacune des cellules de mémoire est réalisée sur une face de contact entre la ligne de source et la ligne de mot, la ligne de source coupant la ligne de mot.

4. Dispositif de mémoire à semi-conducteurs selon la revendication 3, **caractérisé en ce que**
l'un, au choix, de l'émetteur ou du collecteur du transistor bipolaire relié à une extrémité de l'élément résistif variable de chaque cellule de mémoire est réalisé au moyen d'une couche à semi-conducteurs, possédant le même type de conductivité que la ligne de source, sur la ligne de mot pour laquelle la ligne de source coupe la ligne de mot, et
l'élément résistif variable de chaque cellule de mémoire est réalisé, au choix, sur l'émetteur ou le collecteur du transistor bipolaire relié à l'extrémité de l'élément résistif variable à chaque intersection de la ligne de source avec la ligne de mot, et la ligne de bit est réalisée sur l'élément résistif variable.

5. Dispositif de mémoire à semi-conducteurs selon la revendication 4, **caractérisé en ce que**
la ligne de bit possédant un contact qui vient en contact électrique avec l'élément résistif variable est reliée à l'élément résistif variable,
l'une de deux surfaces de parois parallèles du contact et l'une de deux surfaces de parois parallèles de l'élément résistif variable sont alignées l'une avec l'autre pour former une surface verticale, et
l'autre des deux surfaces de parois parallèles du contact et l'autre des deux surfaces de parois parallèles de l'élément résistif variable sont alignées l'une avec l'autre pour former une autre surface verticale.

6. Dispositif de mémoire à semi-conducteurs selon la revendication 4, **caractérisé en ce que**
l'une de deux surfaces de parois parallèles de la ligne de bit et l'une de deux surfaces de parois parallèles de l'élément résistif variable sont alignées l'une avec l'autre pour former une surface verticale, et
l'autre des deux surfaces de parois parallèles de la ligne de bit et l'autre des deux surfaces de parois parallèles de l'élément résistif variable sont alignées l'une avec l'autre pour former une autre surface verticale.

7. Dispositif de mémoire à semi-conducteurs selon la revendication 2, **caractérisé en ce que**
chaque électrode du transistor bipolaire et l'élément résistif variable sont stratifiés perpendiculairement à un substrat à semi-conducteurs.

8. Dispositif de mémoire à semi-conducteurs selon la revendication 2, **caractérisé en ce que**
l'élément résistif variable est un élément de mémoire dans lequel une valeur de résistance est modifiée de manière réversible par l'application d'une tension.

9. Dispositif de mémoire à semi-conducteurs selon la revendication 2, **caractérisé en ce que**
un matériau de l'élément résistif variable est constitué d'un oxyde possédant une structure pérovskite contenant du manganèse.

10. Procédé de fabrication du dispositif de mémoire à semi-conducteurs selon la revendication 2, **caractérisé en ce qu'**il comporte les étapes consistant à :
former une région d'isolation d'élément (103) sur le substrat à semi-conducteurs (100) ;
former une première couche à semi-conducteurs (105) jouant le rôle de ligne de source entre les régions d'isolation d'élément ;
déposer une seconde couche à semiconducteurs (106) dont une partie devient la ligne de mot et une troisième couche à semi-conducteurs (107) dont une partie devient, au choix, un émetteur ou un collecteur du transistor bipolaire relié à une extrémité de l'élément résistif variable, sur la première couche à semi-conducteurs et l'élément d'isolation de région ;
former un motif sur une partie de la troisième couche à semi-conducteurs ;
former un motif sur une autre partie de la troisième couche à semi-conducteurs et de la seconde couche à semi-conducteurs ; et
former l'élément résistif variable sur la troisième couche à semi-conducteurs après y avoir effectué à deux reprises une formation de motif.

11. Procédé de fabrication du dispositif de mémoire à semi-conducteurs selon la revendication 10, **caractérisé en ce que**
au moins une partie de la seconde couche à semi-conducteurs comporte un film en silicium polycristallin.

12. Procédé de fabrication du dispositif de mémoire à semi-conducteurs selon la revendication 10, **caractérisé en ce que**
une partie supérieure de la seconde couche à semi-conducteurs et de la troisième couche à semi-conducteurs comporte un film de silicium épitaxial.

13. Procédé de fabrication du dispositif de mémoire à semi-conducteurs selon la revendication 10, **caractérisé en ce que**
la seconde couche à semi-conducteurs et la troisième couche à semi-conducteurs comportent un film de silicium épitaxial.

14. Procédé de fabrication du dispositif de mémoire à semi-conducteurs selon la revendication 10, **caractérisé en ce qu'**il comporte l'étape consistant à :
implanter une impureté dans chaque couche à semi-conducteurs par implantation ionique d'impuretés après dépôt de la première couche à semi-conducteurs, de la seconde couche à semi-conducteurs et de la troisième couche à semi-conducteurs.

15. Procédé de fabrication du dispositif de mémoire à semi-conducteurs selon la revendication 10, **caractérisé en ce que**
la ligne de source est tracée au moyen d'un premier masque photorésistant, la ligne de mot est tracée au moyen d'un second masque photorésistant et, au choix, l'émetteur ou le collecteur du transistor bipolaire relié à l'extrémité de l'élément résistif variable est tracé au moyen du second masque photo résistant et d'un troisième masque photo résistant.

16. Procédé de fabrication du dispositif de mémoire à semi-conducteurs selon la revendication 10, **caractérisé en ce que**
un trou est ménagé dans un film d'isolation réalisé autour de la troisième couche à semi-conducteurs par gravure arrière de la troisième couche à semi-conducteurs après formation de motifs à deux reprises, l'élément résistif variable est déposé dans le trou, et l'élément résistif variable et la troisième couche à semi-conducteurs sont reliés par auto alignement.

17. Procédé de fabrication du dispositif de mémoire à semi-conducteurs selon la revendication 16, **caractérisé en ce que**
une face supérieure de l'élément résistif variable déposé dans le trou est positionnée au-dessous d'une face supérieure du film d'isolation formé autour de la troisième couche à semi-conducteurs par gravure arrière.
